# FASCICULE DE BREVET EUROPEEN

(11) **EP 3 991 216 B1**
(45) Date de publication et mention de la délivrance du brevet: **13.08.2025**
(21) Numéro de dépôt: 20734742.8
(22) Date de dépôt: 25.06.2020
(51) Int. Cl.: H10H 20/01, H10H 20/818, H10H 20/819, H10H 20/812, H10H 20/813, H10H 20/816, H10H 20/825

(54) **PROCÉDÉ DE FABRICATION D'UN DISPOSITIF OPTOÉLECTRONIQUE À DIODES ÉLECTROLUMINESCENTES DE TYPE AXIAL**
VERFAHREN ZUR HERSTELLUNG EINER OPTOELEKTRONISCHEN VORRICHTUNG MIT LEUCHTDIODEN DES AXIALEN TYPS
METHOD FOR MANUFACTURING AN OPTOELECTRONIC DEVICE WITH AXIAL-TYPE LIGHT-EMITTING DIODES

(30) Priorité: 25.06.2019 FR 1906899
(43) Date de publication de la demande: 04.05.2022
(73) Titulaire: Aledia, 38130 Echirolles (FR); Commissariat à l'Energie Atomique et aux Energies Alternatives, 75015 Paris (FR); Université Grenoble Alpes, 38400 Saint-Martin-d'Hères (FR)
(72) Inventeur: GRUART, Marion, 38120 Saint-Égrève (FR); DAUDIN, Bruno-Jules, 38054 Grenoble Cedex 9 (FR); CHIKHAOUI, Walf, 38500 Voiron (FR)
(74) Mandataire: Cabinet Beaumont
(86) Numéro de dépôt international: PCT/EP2020/067970
(87) Numéro de publication internationale: WO 2020/260549

(56) Documents cités:
- US-A1- 2007 248 132
- US-A1- 2018 351 037
- HAMAD S M ET AL: "Growth of n-type InGaN nanorods on p-type silicon substrates dependent on III/V ratio", 2013 IEEE 39TH PHOTOVOLTAIC SPECIALISTS CONFERENCE (PVSC), IEEE, 16 June 2013 (2013-06-16), pages 2425 - 2427, XP032568993, DOI: 10.1109/PVSC.2013.6744964
- JMERIK V N ET AL: "Site-Controlled Growth of GaN Nanorods with Inserted InGaN Quantum Wells on [mu]-Cone Patterned Sapphire Substrates by Plasma-Assisted MBE", SEMICONDUCTORS, AMERICAN INSTITUTE OF PHYSICS. NEW YORK, US, vol. 52, no. 5, 17 April 2018 (2018-04-17), pages 667 - 670, XP036482828, ISSN: 1063-7826, [retrieved on 20180417], DOI: 10.1134/S1063782618050123

## Description

La présente demande de brevet revendique la priorité de la demande de brevet français FR19/06899.

### Domaine technique

La présente invention concerne de façon générale les dispositifs optoélectroniques à diodes électroluminescentes comprenant des éléments semiconducteurs tridimensionnels, par exemple des microfils, des nanofils, des éléments coniques, tronconiques, pyramidaux, ou pyramidaux tronqués de taille micrométrique ou nanométrique, et les procédés de fabrication de tels dispositifs.

### Technique antérieure

On considère ici plus particulièrement l'amélioration des dispositifs optoélectroniques à diodes électroluminescentes du type axial, comprenant une zone active formée au sommet de chaque élément tridimensionnel. On appelle zone active de la diode électroluminescente la région depuis laquelle est émise la majorité du rayonnement électromagnétique fourni par la diode électroluminescente.

Les éléments tridimensionnels considérés ici comprennent un matériau semiconducteur comportant majoritairement un élément du groupe III et un élément du groupe V (par exemple du nitrure de gallium GaN), appelé par la suite composé III-V. De tels dispositifs sont, par exemple, décrits dans le brevet US 9 728 680 B2**.**

Chaque zone active est prise en sandwich entre l'élément semiconducteur tridimensionnel associé, qui est généralement dopé d'un premier type de conductivité, et une couche semiconductrice du même composé III-V que l'élément semiconducteur et dopée du type de conductivité opposé.

La zone active peut comprendre des puits quantiques multiples, comprenant une alternance de puits quantiques et de couches barrières. Chaque puits quantique peut correspondre à une couche d'un matériau semiconducteur ayant une énergie de bande interdite inférieure à celle de l'élément semiconducteur tridimensionnel et de la couche semiconductrice. Chaque puits quantique peut comprendre un alliage ternaire comprenant un premier élément du groupe III, qui correspond généralement à l'élément du groupe III du composé III-V, l'élément du groupe V du composé III-V, et au moins un deuxième élément du groupe III et chaque couche barrière peut comprendre le composé III-V. La longueur d'onde centrale du rayonnement émis par la zone active dépend de la proportion du deuxième élément du groupe III dans le puits quantique. Il est souhaitable que l'intensité lumineuse émise à la longueur d'onde centrale du rayonnement émis par la zone active soit la plus élevée possible.

Les demandes de brevet: US 2007/0248132 A1 et US 2018/0351037 A1, ainsi que l'article de V. N. Jmerik et al. intitulé: "Site-Controlled Growth of GaN Nanorods with Inserted InGaN Quantum Wells on µ-Cone Patterned Sapphire Substrates by Plasma-Assisted MBE", Semiconductors, Vol. 52, No. 5, avril 2018, pages 667-670, divulguent diverses conditions de croissance connues de la technique antérieure pour des puits quantiques d'InGaN/GaN formés au sein de nanocolonnes cristallines.

### Résumé de l'invention

Ainsi, un objet de la présente invention est de pallier au moins en partie les inconvénients des dispositifs optoélectroniques décrits précédemment et de leurs procédés de fabrication.

Un autre objet de la présente invention est d'améliorer les performances d'émission du dispositif optoélectronique à diodes électroluminescentes du type axial.

Ainsi, la présente invention concerne un procédé de fabrication selon la revendication 1 en annexe, d'un dispositif optoélectronique comprenant des diodes électroluminescentes comprenant la formation d'éléments semiconducteurs tridimensionnels, s'étendant selon des axes parallèles, en un composé III-V, avec une polarité de l'élément du groupe III du composé III-V, le procédé comprenant en outre, pour chaque élément semiconducteur, la formation d'une zone active recouvrant le sommet de l'élément semiconducteur et un empilement de couches semiconductrices recouvrant la zone active, la zone active étant formée par dépôt sous phase vapeur à une pression inférieure à 66,6 mPa et comprenant des puits quantiques séparés par des couches barrières, chaque puits quantique comprenant un alliage ternaire comprenant au moins un premier élément du groupe III, l'élément du groupe V du composé III-V, et un deuxième élément du groupe III, le rapport entre le flux atomique des premier et deuxième éléments du groupe III et le flux atomique de l'élément du groupe V est compris entre 1 et 3.

Selon un mode de réalisation de la présente invention, le rapport entre le flux atomique des premier et deuxième éléments du groupe III et le flux atomique de l'élément du groupe V du composé III-V est compris entre 1 et 1,4, de préférence entre 1,1 et 1,3.

Selon un mode de réalisation de la présente invention, chaque puits quantique est formé à une première température et chaque couche barrière est formée à une deuxième température égale à la première température à 50°C près, de préférence à 30°C près, plus préférentiellement à 10°C près.

Selon un mode de réalisation de la présente invention, les puits quantiques et les couches barrières sont formés par épitaxie par jets moléculaires.

Selon un mode de réalisation de la présente invention, le premier élément du groupe III est identique à l'élément du groupe III du composé III-V.

Selon un mode de réalisation de la présente invention, le rapport entre le flux atomique du premier élément du groupe III et le flux atomique de l'élément du groupe V du composé III-V, pour la formation des puits quantiques, varie de 0,01 à 1.

Selon un mode de réalisation de la présente invention, le rapport entre le flux atomique du deuxième élément du groupe III et le flux atomique de l'élément du groupe V du composé III-V, pour la formation des puits quantiques, varie de 0,05 à 5.

Selon un mode de réalisation de la présente invention, les éléments semiconducteurs tridimensionnels sont formés par épitaxie par jets moléculaires.

Selon un mode de réalisation de la présente invention, le rapport entre le flux atomique de l'élément du groupe III du composé III-V et le flux atomique de l'élément du groupe V du composé III-V, pour la formation des éléments semiconducteurs tridimensionnels, est compris entre 0,35 et 2.

Selon un mode de réalisation de la présente invention, chaque zone active comprend une base, des flancs, et un sommet, la base reposant sur l'élément semiconducteur tridimensionnel, les puits quantiques comprenant des bords exposés sur les flancs, ledit empilement recouvrant les flancs et le sommet.

Selon un mode de réalisation de la présente invention, chaque zone active a une forme de pyramide tronquée de demi-angle au sommet β dont la base repose sur l'élément semiconducteur tridimensionnel, l'angle β étant strictement supérieur à 0°, de préférence compris entre 5° et 80°, plus préférentiellement compris entre 20° et 30°.

Selon un mode de réalisation de la présente invention, au moins une partie de chaque élément semiconducteur tridimensionnel est un microfil, un nanofil, ou un élément tronconique de taille micrométrique ou nanométrique.

Selon un mode de réalisation de la présente invention, les éléments semiconducteurs tridimensionnels sont dopés de type n.

Selon un mode de réalisation de la présente invention, chaque empilement comprend une couche semiconductrice en un composé III-V dopé de type p.

Selon un mode de réalisation de la présente invention, les zones actives sont les régions depuis lesquelles est émise la majorité du rayonnement électromagnétique fourni par les diodes électroluminescentes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 à 5 sont des vues en coupe, partielles et schématiques, de modes de réalisation d'un dispositif optoélectronique à diodes électroluminescentes du type axial obtenu selon des conditions de fabrication idéales ;
les figures 6A à 6D sont des vues en coupe, partielles et schématiques, de structures obtenues à des étapes successives d'un mode de réalisation d'un procédé de fabrication du dispositif optoélectronique représenté en figure 4 ;
les figures 7A à 7C sont des vues en coupe, partielles et schématiques, de structures obtenues à des étapes successives d'un mode de réalisation d'un procédé de fabrication du dispositif optoélectronique représenté en figure 1 ;
les figures 8 et 9 sont respectivement une image obtenue par microscopie électronique à balayage et des profils de pourcentages atomiques d'éléments d'une partie du dispositif de la figure 1 pour des premières conditions de fabrication ;
les figures 10 et 11 sont des figures analogues respectivement aux figures 8 et 9 pour des deuxièmes conditions de fabrication ;
les figures 12 et 13 sont des figures analogues respectivement aux figures 8 et 9 pour des troisièmes conditions de fabrication ; et
la figure 14 représente des courbes d'évolution de l'intensité lumineuse du dispositif de la figure 1 pour les trois conditions de fabrication.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les moyens de commande des dispositifs optoélectroniques sont bien connus et ne sont pas décrits.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation. Lorsqu'un rayonnement présente un spectre de forme générale "en cloche", ayant un maximum, on appelle longueur d'onde du rayonnement, ou longueur d'onde centrale ou principale du rayonnement, la longueur d'onde à laquelle le maximum du spectre est atteint.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

La présente description concerne des dispositifs optoélectroniques comprenant des éléments semiconducteurs tridimensionnels, par exemple des microfils, des nanofils, des éléments coniques de taille micrométrique ou nanométrique, ou des éléments tronconiques de taille micrométrique ou nanométrique. En particulier, un élément conique ou tronconique peut être un élément conique circulaire ou tronconique circulaire ou un élément conique pyramidal ou tronconique pyramidal. Dans la suite de la description, des modes de réalisation sont décrits pour des dispositifs optoélectroniques comprenant des microfils ou des nanofils. Toutefois, ces modes de réalisation peuvent être mis en oeuvre pour des éléments semiconducteurs autres que des microfils ou des nanofils, par exemple des éléments coniques ou tronconiques. Dans la suite de la description, on considère qu'un élément a une "forme cylindrique" lorsqu'il correspond à un solide délimité par une surface cylindrique et par deux plans parallèles, une surface cylindrique étant une surface engendrée par une droite mobile tournant autour d'un axe auquel elle est parallèle. De ce fait, une forme prismatique est un exemple particulier de forme cylindrique. Dans la suite de la description, on considère qu'un élément a une "forme conique" lorsqu'il correspond à un cône, c'est-à-dire un solide délimité par un plan et une surface conique, une surface conique étant une surface engendrée par une droite passant par un point fixe appelé sommet et un point variable décrivant une courbe fermée, le plan ne contenant pas le sommet et coupant la surface conique. De plus, on considère qu'un élément a une "forme tronconique" lorsqu'il correspond à un cône dont la partie supérieure, contenant le sommet, a été retirée.

On entend par alliage ternaire un alliage formé essentiellement de trois éléments (par exemple deux éléments du groupe III et un élément du groupe V) mais bien entendu cet alliage peut être associé avec d'autres éléments (par exemple du groupe III) et former alors un alliage plus complexe par exemple un alliage quaternaire.

Le terme "microfil", "nanofil", "élément conique" ou "élément tronconique" désigne une structure tridimensionnelle de forme allongée, par exemple cylindrique, conique ou tronconique, selon une direction privilégiée, appelée axe par la suite, dont au moins deux dimensions, appelées dimensions mineures, sont comprises entre 5 nm et 2,5 µm, de préférence entre 50 nm et 1 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures, par exemple comprise entre 1 µm et 50 µm.

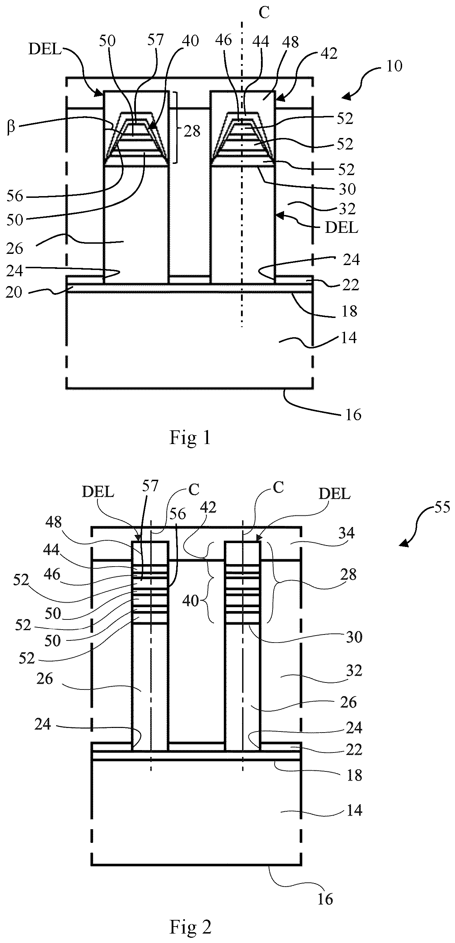

La figure 1 est une vue en coupe, partielle et schématique, d'un exemple d'un dispositif optoélectronique 10 à diodes électroluminescentes de type axial. Le dispositif optoélectronique 10 comprend du bas vers le haut en figure 1 :
- un substrat 14, par exemple un substrat semiconducteur, comprenant des faces parallèles 16 et 18, de préférence planes, la face 18 étant traitée pour promouvoir la croissance de fils. Ce traitement est représenté de façon schématique en figure 1 par une couche 20 de germination en un matériau favorisant la croissance des fils, sur la face 18 du substrat 14 ;
- une couche isolante 22 recouvrant la couche de germination 20 et comprenant des ouvertures 24 traversantes ;
- des fils 26 d'axes C parallèles, deux fils 26 étant représentés sur la figure 1 au moins en partie dopés d'un premier type de conductivité, par exemple dopés de type n ;
- pour chaque fil 26, une tête 28 recouvrant le sommet 30 du fil 26 ;
- une couche isolante 32 recouvrant les faces latérales des fils 26 et partiellement les faces latérales des têtes 28 ; et
- une couche d'électrode 34 recouvrant la couche isolante 32 et en contact avec les têtes 28.

Le dispositif optoélectronique 10 comprend une autre électrode, non représentée, pour polariser la base des fils 26.

Chaque tête 28 comprend du bas vers le haut en figure 1 :
- une zone active 40 recouvrant le sommet 30 du fil 26 ; et
- un empilement semiconducteur 42 recouvrant la zone active 40 et comprenant une couche semiconductrice 44 dopée d'un deuxième type de conductivité opposé à celui du fil 26, par exemple dopée de type p, et recouvrant la zone active 40.

L'ensemble formé par chaque fil 26 et la tête 28 associée forme une diode électroluminescente DEL en configuration axiale.

L'empilement semiconducteur 42 peut en outre comprendre une couche de blocage d'électrons 46 entre la zone active 40 et la couche semiconductrice 44 et une couche semiconductrice de liaison 48 recouvrant la couche semiconductrice 44 du côté opposé à la zone active 40, la couche de liaison 48 étant recouverte par la couche d'électrode 34. La couche de blocage d'électrons 46 en contact avec la zone active 40 et la couche semiconductrice 44 permet d'optimiser la présence des porteurs électriques dans la zone active 40. La couche de liaison 48 peut être du même matériau que la couche semiconductrice 44 et dopée du même type de conductivité que la couche semiconductrice 44 mais avec une concentration de dopants plus importante pour permettre la formation d'un contact ohmique entre la couche semiconductrice 44 et la couche d'électrode 34.

La zone active 40 est la zone de la diode électroluminescente DEL depuis laquelle est émise la majorité du rayonnement électromagnétique fourni par la diode électroluminescente DEL. Selon un exemple, la zone active 40 comporte des moyens de confinement. La zone active 40 comprende des puits quantiques, chaque puits quantique comprenant une couche d'un matériau semiconducteur ayant une énergie de bande interdite inférieure à celle du fil 26 et de la couche semiconductrice 44, de préférence interposée entre deux couches barrières, améliorant ainsi le confinement des porteurs de charge, les couches barrières pouvant être du même matériau que le fil 26 et non intentionnellement dopées. A titre d'exemple, en figure 1, on a représenté une alternance selon l'axe C de deux puits quantiques 50 et de trois couches barrières 52. De préférence, la zone active 40 comprend entre trois et quinze puits quantiques 50, de préférence environ dix puits quantiques 50.

Dans le présent mode de réalisation, la zone active 40 a une forme pyramidale ayant des flancs inclinés 56 et un sommet 57. Dans la zone active 40, les couches formant les puits quantiques 50 et les couches barrière 52 sont sensiblement planes. L'empilement 42 des couches 44, 46, et 48 recouvre les flancs 56 et le sommet 57 de la zone active 40. De ce fait, les couches 44 et 46 sont situées en regard des bords latéraux de chaque puits quantique 50. Les flancs 56 sont inclinés d'un angle β par rapport à l'axe C du fil 26. Selon un mode de réalisation, l'angle β est compris entre 0° et 80°, de préférence entre 10° et 45°, plus préférentiellement entre 20° et 30°.

Un exemple de procédé de fabrication du dispositif optoélectronique 10 comprend la croissance des fils 26, des zones actives 40 et des empilements semiconducteurs 42 en mettant en oeuvre un procédé de croissance qui favorise une croissance cristalline selon l'axe C des fils 26. Le procédé de croissance des fils peut être un procédé du type dépôt chimique en phase vapeur (CVD, sigle anglais pour Chemical Vapor Deposition) ou dépôt chimique en phase vapeur aux organométalliques (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy), ou la MOCVD assistée au plasma (PA-MOCVD), ou un procédé tel que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PA-MBE), dépôt par couches minces atomiques (ALD, acronyme anglais pour Atomic Layer Deposition) ou l'épitaxie en phase vapeur aux hydrures (HVPE, acronyme anglais pour Hydride Vapor Phase Epitaxy ou Halide Vapor Phase Epitaxy) peuvent être utilisés. Toutefois, des procédés électrochimiques peuvent être utilisés, par exemple le dépôt en bain chimique (CBD, sigle anglais pour Chemical Bath Deposition), les procédés hydrothermiques, la pyrolise d'aérosol liquide ou l'électrodépôt.

La figure 2 est une vue en coupe, partielle et schématique d'un autre mode de réalisation d'un dispositif optoélectronique 55. Le dispositif optoélectronique 55 comprend l'ensemble des éléments du dispositif optoélectronique 10 représenté en figure 1 à la différence que la zone active 40 a une forme cylindrique dont les flancs 56 ne sont pas inclinés. L'empilement 42 des couches 44, 46, et 48 recouvre seulement le sommet 57 de la zone active 40.

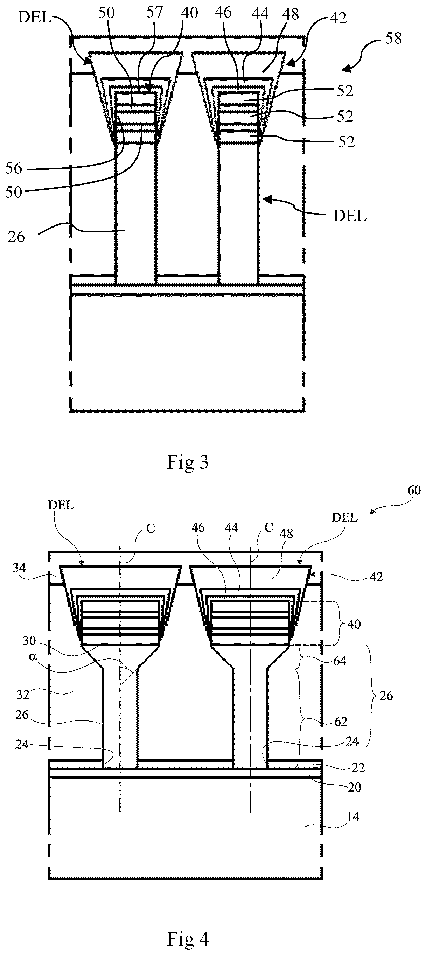

La figure 3 est une vue en coupe, partielle et schématique, d'un mode de réalisation d'un dispositif optoélectronique 58. Le dispositif optoélectronique 58 comprend l'ensemble des éléments du dispositif optoélectronique 10 représenté en figure 1 à la différence que la zone active 40 a la même forme que la zone active 40 du dispositif optoélectronique 55 représentée en figure 2, c'est-à-dire cylindrique. L'empilement 42 des couches 44, 46, et 48 recouvre les flancs 56 et le sommet 57 de la zone active 40. De ce fait, les couches 44, 46, et 48 sont situées en regard des bords latéraux de chaque puits quantique 50. Un avantage du dispositif optoélectronique 10 représenté en figure 1 par rapport au dispositif optoélectronique 58 représenté en figure 3 est que les risques de formation de passages pour le courant entre l'empilement semiconducteur 42 et le fil 26 sont réduits. En outre, l'épaisseur des parties de l'empilement 42 au niveau des flancs 56 de la zone active 40 peut être supérieure pour le dispositif optoélectronique 10 représenté en figure 1 par rapport au dispositif optoélectronique 58 représenté en figure 3, ce qui permet de réduire la résistance électrique de ces parties.

La figure 4 est une vue en coupe d'un mode de réalisation d'un dispositif optoélectronique 60. Le dispositif optoélectronique 60 comprend l'ensemble des éléments du dispositif optoélectronique 58 représenté en figure 3 à la différence que chaque fil 26 comprend une portion inférieure 62 de section droite sensiblement constante se prolongeant par une portion supérieure 64 de forme évasée vers l'extérieur dans laquelle la section droite augmente selon l'axe C en s'éloignant du substrat 14. Comme cela apparaît sur cette figure, les couches de l'empilement semiconducteur 42 ne s'étendent pas au contact du fil 26 au moins au niveau du sommet du fil 26. Dans le mode de réalisation représenté en figure 4, la portion supérieure 64 comprend des facettes sensiblement planes inclinées par rapport à l'axe C d'un angle α. De façon générale, on appelle angle de la portion supérieure 64 le demi-angle au sommet α du tronc de cône d'axe C à base circulaire dans lequel est inscrite la portion supérieure 64. Selon un mode de réalisation, l'angle α est strictement supérieur à 0°, de préférence entre 5° et 50°, plus préférentiellement entre 5° et 30°.

De préférence, pour chaque fil 26, le sommet 30 de la portion supérieure 62 du fil 26 correspond à une face sensiblement plane orthogonale à l'axe C du fil 26. De préférence, la surface du sommet 30 est supérieure d'au moins 20 % à la section droite de la portion inférieure 62 du fil 26. La hauteur de la portion supérieure 64 de chaque fil 26 mesurée selon l'axe C peut être comprise entre 5 nm et 2 µm, de préférence entre 20 nm et 500 nm. La hauteur de la portion inférieure 62 de chaque fil 26 mesurée selon l'axe C peut être comprise entre 200 nm et 5 µm. Pour chaque fil 26, le diamètre moyen de la portion inférieure 62 du fil 26, qui est le diamètre du disque de même surface que la section droite du fil 26, peut être compris entre 50 nm et 10 µm, de préférence entre 100 nm et 2 µm, de préférence entre 100 nm et 1 µm. La section droite de la portion inférieure 62 du fil 26 peut avoir différentes formes, par exemple ovale, circulaire ou polygonale, en particulier rectangulaire, carrée ou hexagonale.

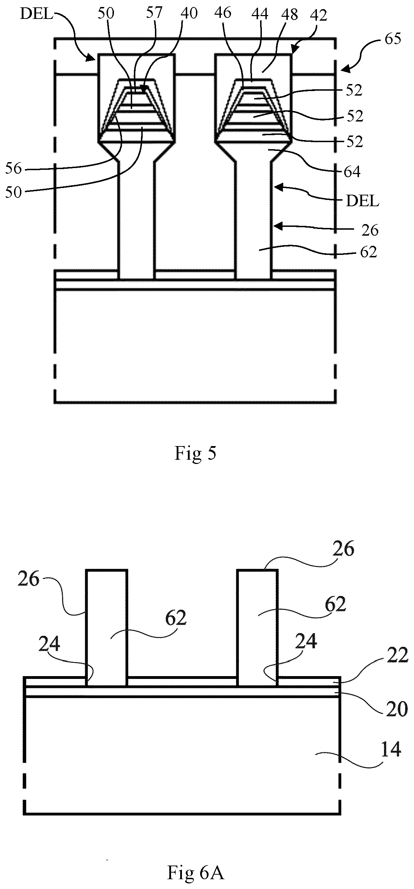

La figure 5 est une vue en coupe, partielle et schématique, d'un mode de réalisation d'un dispositif optoélectronique 65. Le dispositif optoélectronique 65 comprend l'ensemble des éléments du dispositif optoélectronique 10 représenté en figure 1 à la différence que le fil 26 a la structure du fil 26 du dispositif optoélectronique 60 représenté en figure 4.

Dans les modes de réalisation décrits précédemment en relation avec les figures 1, 3, 4, et 5, l'empilement semiconducteur 42 est directement au contact de chaque puits quantique 50 de la zone active 40 dans la mesure où il vient en contact mécanique avec les bords latéraux de chaque puits quantique 50. L'injection de trous dans chaque puits quantique peut donc se produire par les bords latéraux du puits quantique. De plus, la surface d'échange entre l'empilement 42 et la zone active 40 est augmentée par rapport à la surface d'échange de la figure 2 qui correspond à une surface de contact entre deux plans.

Les fils 26, les couches semiconductrices 44 et les couches de liaison 48 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple le phosphore ou l'arsenic. De façon générale, les éléments dans le composé III-V peuvent être combinés avec différentes fractions molaires. Les composés III-V des fils et des couches 44, 48 peuvent comprendre un dopant, par exemple du silicium qui est un dopant de type n pour les composés III-N ou du magnésium qui est un dopant de type p pour les composés III-N.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Le matériau constituant la couche de germination 20 est choisi de façon à favoriser la croissance des fils 26 selon la même polarité. De préférence, le matériau constituant la couche de germination 20 est choisi de préférence de façon à favoriser la croissance du composé III-V selon la polarité de l'élément du groupe III, appelé par la suite polarité métal. Selon la présente invention, les conditions de croissance sont définies de sorte que lorsqu'on fait croître un deuxième matériau semiconducteur polaire sur un premier matériau semiconducteur polaire, le deuxième matériau semiconducteur conserve la polarité du premier matériau semiconducteur. De ce fait, la polarité des puits quantiques 50 est la même que celle des fils 26. La croissance selon la polarité métal, par exemple selon la polarité Ga, du matériau semiconducteur comprenant le composé III-V permet, de façon avantageuse, notamment lors de la formation des puits quantiques, de réduire l'incorporation dans le matériau semiconducteur, par la surface libre du matériau semiconducteur, d'impuretés responsables de recombinaisons non radiatives par rapport au cas où la croissance du matériau semiconducteur est réalisée selon la polarité de l'élément du groupe V, par exemple selon la polarité N.

Le matériau semiconducteur du puits quantique ou des puits quantiques de la zone active 40 peut comprendre le composé III-V du fil 26 et de la couche semiconductrice 44 dans lequel au moins un deuxième élément du groupe III est incorporé. A titre d'exemple, dans le cas de fils 26 constitués de GaN, le deuxième élément du groupe III est par exemple l'indium (In). Le pourcentage atomique du deuxième élément du groupe III est fonction des propriétés optiques souhaitées et du spectre d'émission de la diode électroluminescente DEL. Lorsque la portion supérieure 64 du fil 26 est présente et n'est pas intentionnellement dopée, celle-ci peut remplacer l'une des couches barrières de la zone active 40.

La couche de blocage d'électrons 46 peut être formée en un alliage ternaire, par exemple en nitrure de gallium et d'aluminium (AlGaN) ou en nitrure d'indium et d'aluminium (AlInN).

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V, tel que du GaN ou du GaAs, ou un substrat conducteur, par exemple un substrat métallique, notamment en cuivre, en titane, en molybdène, en un alliage à base de nickel ou en acier, ou un substrat en saphir. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator).

La couche de germination 20 est en un matériau favorisant la croissance des fils 26. A titre d'exemple, le matériau composant la couche de germination 20 peut être un nitrure, un carbure ou un borure d'un métal de transition de la colonne IV, V ou VI du tableau périodique des éléments ou une combinaison de ces composés. A titre d'exemple, la couche de germination 20 peut être en nitrure d'aluminium (AlN). La couche de germination 20 peut avoir une structure monocouche ou correspondre à un empilement de deux couches ou de plus de deux couches.

La couche isolante 22 peut être en un matériau diélectrique, par exemple en oxyde de silicium (SiO₂) ou en nitrure de silicium (SiₓN_{y}, où x est environ égal à 3 et y est environ égal à 4, par exemple du Si₃N₄). A titre d'exemple, l'épaisseur de la couche isolante 22 est comprise entre 5 nm et 100 nm, par exemple égale à environ 30 nm. La couche isolante 22 peut avoir une structure monocouche ou correspondre à un empilement de deux couches ou de plus de deux couches.

La couche isolante 32 peut être en un matériau diélectrique, par exemple en oxyde de silicium (SiO₂) ou en nitrure de silicium (SiₓN_{y}, où x est environ égal à 3 et y est environ égal à 4, par exemple du Si₃N₄). La couche isolante 32 peut avoir une structure monocouche ou correspondre à un empilement de deux couches ou de plus de deux couches. A titre d'exemple, la couche isolante 32 peut être constituée d'un matériau polymère, d'un matériau inorganique ou d'une combinaison d'un matériau polymère et d'un matériau inorganique. A titre d'exemple, le matériau inorganique peut être de l'oxyde de titane (TiO₂) ou de l'oxyde d'aluminium (AlₓO_{y}, où x est environ égal à 2 et y est environ égal à 3, par exemple du Al₂O₃).

La couche d'électrode 34 est adaptée à polariser la zone active 40 recouvrant chaque fil 26 et à laisser passer le rayonnement électromagnétique émis par les diodes électroluminescentes DEL. Le matériau formant la couche d'électrode 34 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 34 a une épaisseur comprise entre 5 nm et 200 nm, de préférence entre 20 nm et 50 nm.

Les inventeurs ont mis en évidence que des diodes électroluminescentes tridimensionnelles de type axial ayant les propriétés optiques souhaitées pouvaient être fabriquées lorsque les fils 26 en composé III-V sont de polarité de l'élément du groupe III du composé III-V et que les zones actives 40 sont formées par un procédé de dépôt en phase vapeur à une pression inférieure à 1,33 mPa (10⁻⁵ Torr), notamment par PA-MBE, avec des conditions de croissance particulières des puits quantiques et des couches barrières. Pour assurer une croissance optimale selon la polarité métal de chaque matériau semiconducteur composant les différentes parties de la diode électroluminescente tridimensionnelle assurant une bonne planéité aux interfaces entre les puits quantiques et les couches barrières, le rapport entre la somme des flux atomiques de tous les éléments du groupe III composant le matériau semiconducteur et le flux atomique de l'élément du groupe V composant le matériau semiconducteur est choisi supérieur à 1. Ceci permet notamment d'éviter d'avoir une croissance de type pyramidale ou la formation de rugosités sur la surface libre du matériau semiconducteur.

Pour obtenir une croissance planaire des couches de la zone active 40 avec une rupture marquée en composition entre chaque puits quantique 50 et la couche barrière 52 formée ultérieurement sur le puits quantique et en contact avec le puits quantique, le rapport entre la somme des flux atomiques de tous les éléments du groupe III composant le matériau semiconducteur et le flux atomique de l'élément du groupe V composant le matériau semiconducteur est choisi supérieur à 1, de préférence entre 1 et 1,8, de préférence variant de 1 à 1,4, encore plus préférentiellement de 1,1 à 1,3. En effet, la proportion réduite du deuxième élément du groupe III résiduel à la fin de la formation du puits quantique permet d'éviter l'incorporation de ce deuxième élément du groupe III dans la couche barrière ultérieure, ce qui viendrait dégrader l'obtention d'une transition abrupte de composition entre le puits quantique et la couche barrière. Ceci permet en outre de conserver sensiblement la même température dans le réacteur lors de la formation des puits quantiques et de couches barrières et donc d'éviter des phases de changement de température entre la formation d'un puits quantique et d'une couche barrière, en particulier de montées en température pour la formation d'une couche barrière après élimination par exemple par évaporation sous vide du deuxième élément du groupe III résiduel en fin de formation d'un puits quantique.

De plus, dans les modes de réalisation décrits précédemment en relation avec les figures 1, 3, 4, et 5, dans lesquels l'empilement semiconducteur 42 est directement au contact de chaque puits quantique 50 de la zone active 40, une meilleure injection de trous dans des puits quantiques 50 bien délimités est ainsi obtenue.

Les figures 6A à 6D sont des vues en coupe, partielles et schématiques, de la structure obtenue à des étapes successives d'un mode de réalisation d'un procédé de fabrication du dispositif optoélectronique 60 représenté en figure 4.

La figure 6A représente la structure obtenue après les étapes suivantes :
- formation sur le substrat 14 de la couche de germination 20 ;
- formation de la couche isolante 22 sur la couche de germination 20 ;
- formation des ouvertures 24 dans la couche isolante 22 pour exposer des portions de la couche de germination 20 aux emplacements souhaités des fils 26, le diamètre des ouvertures 24 correspondant sensiblement au diamètre moyen des portions inférieures 62 des fils 26 ; et
- croissance des portions inférieures 62 des fils 26 à partir de la couche de germination 20 dans les ouvertures 24.

La couche de germination 20 et la couche isolante 22 peuvent être formées par CVD, dépôt physique en phase vapeur (PVD, signe anglais pour Physical Vapor Deposition) ou ALD.

Selon un mode de réalisation, la croissance des portions inférieures 62 des fils 26 est réalisée par PA-MBE. La pression dans le réacteur est comprise entre 10⁻⁴ Torr (13,3 mPa) et 10⁻⁷ Torr (0,0133 mPa). Les conditions de croissance dans le réacteur sont adaptées pour favoriser une croissance préférentielle de la portion inférieure 62 de chaque fil 26 selon son axe C. Cela signifie que la vitesse de croissance du fil 26 selon l'axe C est nettement supérieure, de préférence d'au moins un ordre de grandeur, à la vitesse de croissance du fil 26 selon une direction perpendiculaire à l'axe C. On appelle rapport III/V le rapport entre le flux atomique de l'élément du groupe III du composé III-V et le flux atomique de l'élément du groupe V du composé III-V. Le rapport III/V est de préférence inférieur à 1,4, notamment compris entre 0,3 et 1,4, plus préférentiellement compris entre 0,35 et 1, par exemple égal à environ 0,8. La température dans le réacteur est, par exemple, comprise entre 600°C et 1000°C, de préférence entre 700°C et 950°C, plus préférentiellement entre 800°C et 925°C, par exemple environ 900°C.

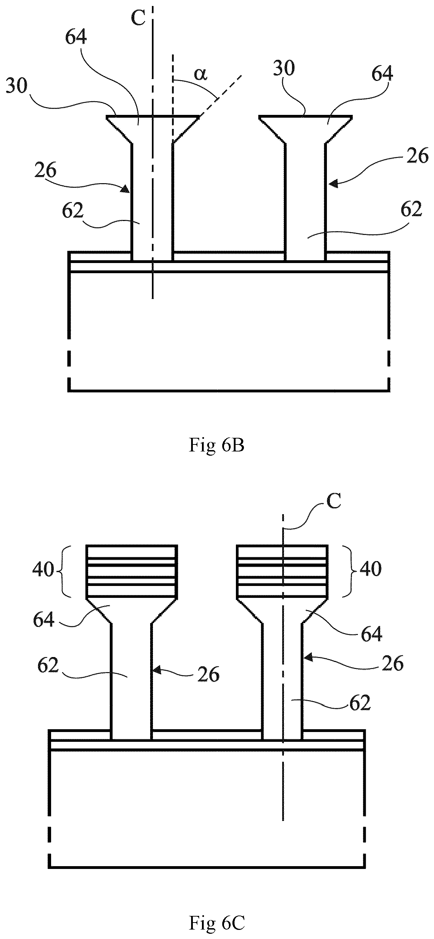

La figure 6B représente la structure obtenue après la croissance des portions supérieures 64 des fils 26. Selon un mode de réalisation, la croissance des portions supérieures 64 des fils 26 est réalisée par PA-MBE. La pression dans le réacteur est comprise entre 10⁻⁴ et 10⁻⁷ Torr. Le rapport III/V est de préférence supérieur à 1,1, notamment compris entre 1,1 et 2, plus préférentiellement compris entre 1,3 et 1,6, par exemple égal à environ 1,4. La température dans le réacteur est inférieure à la température utilisée pour la formation des portions inférieures 62 des fils lorsqu'ils sont réalisés par MBE, de préférence d'au moins 50°C, par exemple comprise entre 550°C et 950°C, de préférence entre 650°C et 900°C, plus préférentiellement entre 750°C et 875°C, par exemple environ 850°C. Ceci permet d'obtenir un élargissement de la portion supérieure 64 de chaque fil 26, de préférence d'au moins 20 %. On obtient alors une portion supérieure 64 dont la paroi latérale forme l'angle α avec l'axe C comme cela a été décrit précédemment.

De façon avantageuse, lorsque les portions supérieures 64 des fils 26 sont formées par PA-MBE, les dimensions de la surface du sommet 30 de chaque portion supérieure 64, où est formée la zone active 40, sont sensiblement fixées par le rapport III/V utilisé pour la formation de la portion supérieure 64, et sont sensiblement indépendantes du diamètre moyen de la portion inférieure 62 du fil 26 depuis laquelle s'étend la portion supérieure 64. Ceci permet donc de commander avec précision les dimensions de la surface du sommet 30 de la portion supérieure 64 et donc les dimensions latérales de la zone active 40. Ceci permet de compenser au moins partiellement les variations des diamètres moyens des portions inférieures 62 des fils 26 qui peuvent résulter du procédé de fabrication des fils.

En outre, la longueur d'onde du rayonnement émis par un puits quantique dépend notamment de la proportion du deuxième élément du groupe III, par exemple l'indium, incorporé dans le composé ternaire du puits quantique. Cette proportion dépend elle-même des dimensions latérales de la zone active 40. De ce fait, un contrôle précis des dimensions latérales de la zone active 40 permet de contrôler avec précision la longueur d'onde du rayonnement émis par la zone active 40. Les variations des longueurs d'ondes du rayonnement émis par les diodes électroluminescentes peuvent donc être réduites.

La figure 6C représente la structure obtenue après la croissance des couches des zones actives 40. Selon un mode de réalisation, la croissance des couches des zones actives 40 est réalisée par PA-MBE. La pression dans le réacteur est comprise entre 10⁻⁴ et 10⁻⁷ Torr. Pour la formation de chaque puits quantique, un deuxième élément du groupe III est ajouté dans le réacteur. Le rapport entre les flux atomiques des éléments du groupe III et le flux atomique de l'élément du groupe V est égal au flux III/V utilisé pour la formation des portions supérieures 64 des fils 26 lorsqu'elles sont réalisées par MBE. La température dans le réacteur est, par exemple, comprise entre 500°C et 750°C, de préférence entre 600°C et 700°C.

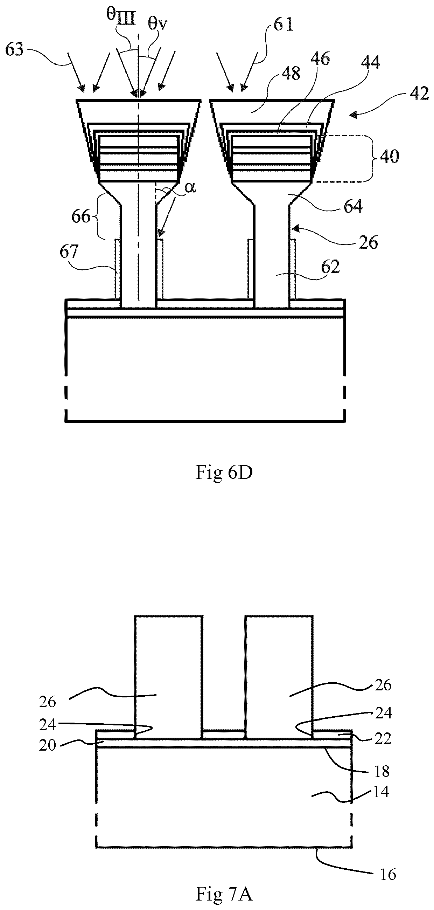

La figure 6D représente la structure obtenue après la croissance des couches des empilements semiconducteurs 42. Selon un mode de réalisation, la croissance des couches des empilements semiconducteurs 42 est réalisée par PA-MBE. La structure est en rotation dans le réacteur autour d'un axe vertical. La pression dans le réacteur est comprise entre 10⁻⁴ et 10⁻⁷ Torr. Pour la formation de la couche de blocage d'électrons 46, un troisième élément du groupe III est ajouté dans le réacteur, le rapport III/V est de préférence proche de 1 et le rapport entre le flux atomique du troisième élément et le flux atomique de l'élément du groupe V est compris entre 0,1 et 0,3. Pour la formation de la couche de blocage d'électrons 46, la température dans le réacteur est, par exemple, comprise entre 600°C et 1000°C, de préférence entre 700°C et 950°C, plus préférentiellement entre 750°C et 900°C. Pour la formation de la couche semiconductrice 44 ou 48, le rapport III/V est de préférence inférieur à 1,3, notamment compris entre 1,1 et 1,3. Pour la formation de la couche semiconductrice 44 ou 48, la température dans le réacteur est, par exemple, comprise entre 700°C et 900°C, de préférence entre 750°C et 850°C. Les flux atomiques de l'élément du groupe III et de l'élément du groupe V sont représentés de façon schématique en figure 6D par des flèches 63, 61. On appelle θ_{III} l'angle d'incidence du flux atomique de l'élément du groupe III et θᵥ celui du flux atomique de l'élément du groupe V par rapport à l'axe C des fils. Les angles θ_{III} et θ_{V} dépendent notamment du type de réacteur utilisé. Lorsque le plus grand des angles θ_{III} et θ_{V} est inférieur à l'angle α, on obtient une zone 66 sur la portion inférieure 62 de chaque fil 26 où il n'y a pas de dépôt alors que l'on peut observer la formation d'un dépôt 67 non souhaité en partie basse de la portion inférieure 62 de chaque fil 26. Pour chaque fil 26, il n'y a pas de continuité entre les couches semiconductrices de l'empilement semiconducteur 42 et le dépôt 67 formé simultanément sur les parois latérales du fil 26, de sorte que la formation d'un court-circuit est empêchée.

Sur les figures 6C et 6D, on a représenté chaque zone active 40 avec une section droite sensiblement constante selon l'axe C. A titre de variante, les conditions de croissance de la zone active 40 peuvent être sélectionnées de façon que la zone active 40 ait une forme de pyramide tronquée d'axe C avec une section droite qui diminue selon l'axe C en s'éloignant du substrat 14. Une telle forme peut être obtenue sans perte notable du volume du puits quantique ou des puits quantiques par rapport au cas où la section droite est constante. Une zone active 40 en forme de pyramide tronquée permet, de façon avantageuse, d'augmenter l'épaisseur de la couche semiconductrice 44 qui la recouvre et d'améliorer la passivation de la surface de la zone active 40.

Selon un autre mode de réalisation, la croissance des portions inférieures 62 des fils 26, et/ou des portions supérieures 64 des fils 26 est réalisée par un autre procédé qu'un procédé de dépôt en phase vapeur à une pression inférieure à 1,33 mPa (10⁻⁵ Torr), notamment par PA-MBE. Le procédé de croissance doit néanmoins permettre la formation de la portion supérieure 64 évasée de chaque fil 26.

Selon un autre mode de réalisation, la croissance des portions inférieures 62 des fils 26, et/ou des portions supérieures 64 des fils 26, et/ou des zones actives 40 est réalisée par MOCVD, par MBE, notamment MBE assistée par ammoniac, par épitaxie en couches minces atomiques (ALE, sigle anglais pour atomic layer epitaxy) . A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBT), l'arsine (AsH₃), ou le diméthylhydrazine asymétrique (UDMH). On appelle rapport III/V le rapport entre le flux de gaz du précurseur de l'élément du groupe III et le flux de gaz du précurseur de l'élément du groupe V.

Les figures 7A à 7C sont des vues en coupe, partielles et schématiques, de la structure obtenue à des étapes successives d'un mode de réalisation d'un procédé de fabrication du dispositif optoélectronique 10 représenté en figure 1.

La figure 7A représente la structure obtenue après les étapes décrites précédemment en relation avec la figure 6A.

Selon un mode de réalisation, la croissance des fils 26 est réalisée par PA-MBE avec la polarité de l'élément du groupe III. La pression dans le réacteur est comprise entre 5.10⁻⁴ Torr (66,6 mPa) et 10⁻⁷ Torr (0,0133 mPa). Les conditions de croissance dans le réacteur sont adaptées pour favoriser une croissance préférentielle de chaque fil 26 selon son axe C. Le rapport III/V est compris entre 1 et 2, de préférence compris entre 1,2 et 1,6. La température dans le réacteur est, par exemple, comprise entre 600°C et 900°C, de préférence entre 750°C et 850°C.

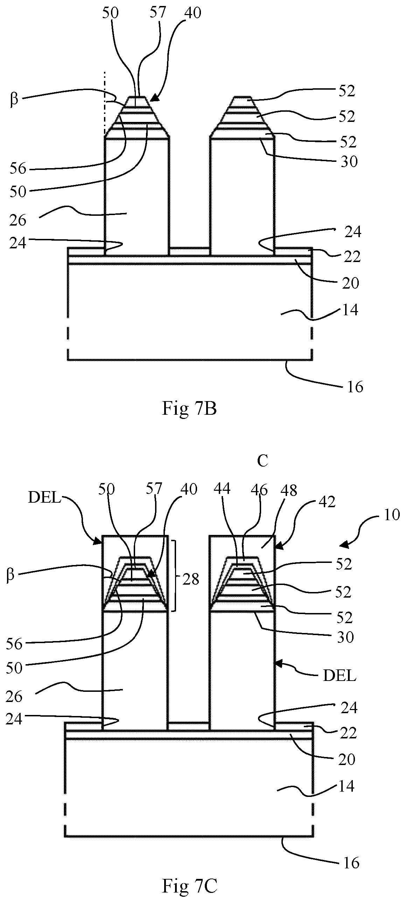

La figure 7B représente la structure obtenue après la croissance des couches des zones actives 40. Selon un mode de réalisation, la croissance des couches des zones actives 40 est réalisée par PA-MBE. La pression dans le réacteur est comprise entre 5.10⁻⁴ Torr (66,6 mPa) et 10⁻⁷ Torr (0,0133 mPa). Les conditions de croissance dans le réacteur sont adaptées pour favoriser une croissance préférentielle de couches de la zone active 40 de façon planaire selon son axe C. Pour chaque puits quantique 50, le rapport entre le flux atomique du premier élément du groupe III et le flux atomique de l'élément du groupe V est compris entre 0,15 et 0,5. Le rapport entre le flux atomique du deuxième élément du groupe III et le flux atomique de l'élément du groupe V est compris entre 0,5 et 2,85. Le rapport entre le flux atomique des premier et deuxième éléments du groupe III et le flux atomique de l'élément du groupe V, également appelé rapport m/V, est compris entre 1 et 3, de préférence compris entre 1 et 1,8. La température de la surface de croissance dans le réacteur est, par exemple, comprise entre 500°C et 800°C, de préférence entre 600°C et 700°C. Pour chaque couche barrière 52, le rapport III/V est compris entre 0,01 et 2 de préférence compris entre 0,2 et 0,6 afin de favoriser spécifiquement la croissance de la zone active sous forme de pyramide. On accepte ici une rugosification limitée potentielle de la couche barrière si l'indium résiduel à incorporer est en quantité insuffisante. Le rapport entre le flux atomique du deuxième élément du groupe III et le flux atomique de l'élément du groupe V est compris entre 0 et 0,5, de préférence égal à environ 0. La température dans le réacteur est, par exemple, comprise entre 500°C et 800°C, de préférence entre 600°C et 700°C.

Selon un mode de réalisation, la température de la surface de croissance dans le réacteur pour la formation de chaque puits quantique et la température de la surface de croissance dans le réacteur pour la formation de chaque couche barrière sont égales à 50°C près, de préférence à 30°C près, plus préférentiellement à 10°C près. Ceci permet d'éviter des phases de changement de température entre la formation d'un puits quantique et d'une couche barrière, en particulier de montées en température pour la formation d'une couche barrière.

La figure 7C représente la structure obtenue après les étapes décrites précédemment en relation avec la figure 6D.

Des premier, deuxième, et troisième essais ont été réalisés, les fils 26 étaient en GaN dopé de type n. Le diamètre moyen de chaque fil 26 était sensiblement égal à 200 nm. Chaque zone active 40 comprenait dix puits quantiques en InGaN avec des couches barrières de InGaN non dopées intentionnellement, les couches barrières ayant un pourcentage atomique en indium inférieur ou égal à celui des puits quantiques. Les puits quantiques et les couches barrières ont été formés par PA-MBE. Chaque empilement semiconducteur 42 comprenait une couche de blocage 46 en AlGaN et une couche semiconductrice 44 en GaN dopé de type p. Les couches de blocage 46 en AlGaN ont été formées par PA-MBE avec un rapport (Ga+Al)/N de 1. Les couches semiconductrices 44 de GaN dopé de type p ont été formées par PA-MBE avec un rapport Ga/N de 1 et une température de 850°C.

Pour le premier essai, les puits quantiques en InGaN ont été formés avec un rapport (Ga+In)/N de 1,2. Pour le deuxième essai, les puits quantiques en InGaN ont été formés avec un rapport (Ga+In)/N de 1,6. Pour le troisième essai, les puits quantiques en InGaN ont été formés avec un rapport (Ga+In)/N de 2.

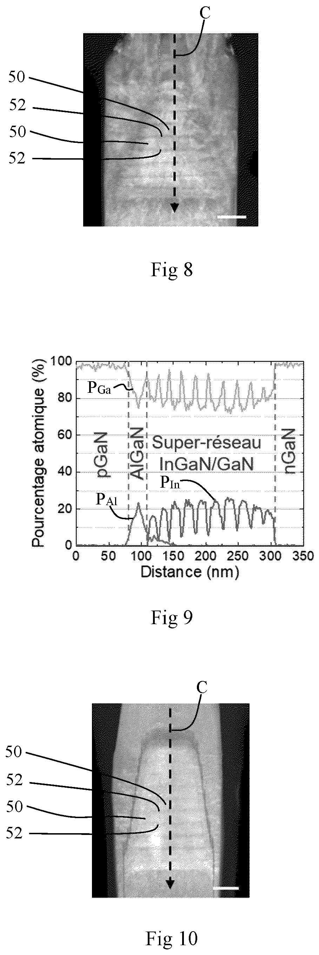

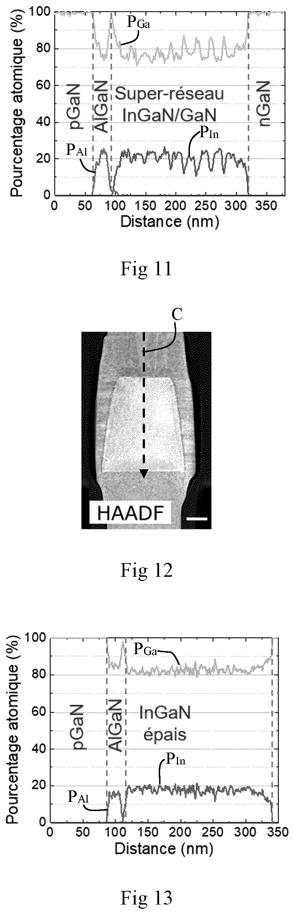

Les figures 8, 10, et 12 sont des images, obtenues par microscopie électronique en transmission à balayage, de l'extrémité supérieure de fils 26, des zones actives 40 et des empilements semiconducteurs respectivement pour les premier, deuxième, et troisième essais. Les figures 9, 11, et 13 représentent chacune des profils P_{Ga}, P_{In}, et P_{Al} des pourcentages atomiques selon l'axe C du fil 26 respectivement en gallium, indium, et aluminium obtenus par spectroscopie de rayons X à dispersion d'énergie (EDX, Energy Dispersive X-Ray), les figures 9, 11, et 13 étant obtenues respectivement pour les premier, deuxième, et troisième essais.

Comme cela apparaît sur ces figures, la concentration d'indium dans les puits quantiques 50 est sensiblement la même pour les trois essais. La concentration d'indium dans les couches barrières 52 varie selon les essais. Pour le premier essai, on observe la présence d'indium dans les couches barrières avec toutefois une différence nette de concentrations d'indium entre les puits quantiques 50 et les couches barrières 52. Au contraire, lorsque le rapport (Ga+In)/N est supérieur à 2, les puits quantiques 50 ne peuvent plus être distingués des couches barrière 52.

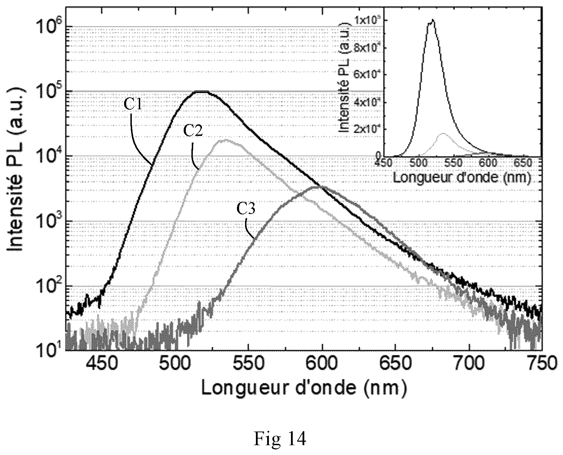

La figure 14 représente des courbes d'évolution C1, C2, et C3, de l'intensité lumineuse PL (exprimée en unité arbitraire) en fonction de la longueur d'onde respectivement pour le premier, deuxième, et troisième essai. Comme cela apparaît sur ces essais, le maximum d'intensité lumineuse est obtenu pour le premier essai.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. Enfin, la mise en oeuvre pratique des modes de réalisation et variantes décrits est à la portée de l'homme du métier à partir des indications fonctionnelles données ci-dessus.

Les revendications qui suivent définissent l'objet de la présente invention.

## Revendications

1. Procédé de fabrication d'un dispositif optoélectronique (10 ; 55 ; 58 ; 60 ; 65) comprenant des diodes électroluminescentes (DEL) comprenant la formation d'éléments semiconducteurs tridimensionnels (26), s'étendant selon des axes (C) parallèles, en un composé III-V, avec une polarité de l'élément du groupe III du composé III-V, le procédé comprenant en outre, pour chaque élément semiconducteur, la formation d'une zone active (40) recouvrant le sommet (30) de l'élément semiconducteur et un empilement (42) de couches semiconductrices recouvrant la zone active, la zone active étant formée par dépôt sous phase vapeur à une pression inférieure à 66,6 mPa et comprenant des puits quantiques (50) séparés par des couches barrières (52), chaque puits quantique (50) comprenant un alliage ternaire comprenant au moins un premier élément du groupe III, l'élément du groupe V du composé III-V, et un deuxième élément du groupe III, **caractérisé en ce que** le rapport entre le flux atomique des premier et deuxième éléments du groupe III et le flux atomique de l'élément du groupe V est compris entre 1 et 3.

2. Procédé selon la revendication 1, dans lequel le rapport entre le flux atomique des premier et deuxième éléments du groupe III et le flux atomique de l'élément du groupe V du composé III-V est compris entre 1 et 1,4, de préférence entre 1,1 et 1,3.

3. Procédé selon la revendication 1 ou 2, dans lequel chaque puits quantique (50) est formé à une première température et chaque couche barrière (52) est formée à une deuxième température égale à la première température à 50°C près, de préférence à 30°C près, plus préférentiellement à 10°C près.

4. Procédé selon l'une quelconque des revendications 1 à 3, dans lequel les puits quantiques (50) et les couches barrières (52) sont formés par épitaxie par jets moléculaires.

5. Procédé selon l'une quelconque des revendications 1 à 4, dans lequel le premier élément du groupe III est identique à l'élément du groupe III du composé III-V.

6. Procédé selon l'une quelconque des revendications 1 à 5, dans lequel le rapport entre le flux atomique du premier élément du groupe III et le flux atomique de l'élément du groupe V du composé III-V, pour la formation des puits quantiques (50), varie de 0,01 à 1.

7. Procédé selon la revendication 4 ou 5, dans lequel le rapport entre le flux atomique du deuxième élément du groupe III et le flux atomique de l'élément du groupe V du composé III-V, pour la formation des puits quantiques (50), varie de 0,05 à 5.

8. Procédé selon l'une quelconque des revendications 1 à 7, dans lequel les éléments semiconducteurs tridimensionnels (26) sont formés par épitaxie par jets moléculaires.

9. Procédé selon la revendication 8, dans lequel le rapport entre le flux atomique de l'élément du groupe III du composé III-V et le flux atomique de l'élément du groupe V du composé III-V, pour la formation des éléments semiconducteurs tridimensionnels (26), est compris entre 0,35 et 2.

10. Procédé selon l'une quelconque des revendications 1 à 9, dans lequel chaque zone active (40) comprend une base, des flancs (56), et un sommet (57), la base reposant sur l'élément semiconducteur tridimensionnel (26), les puits quantiques comprenant des bords exposés sur les flancs, ledit empilement (42) recouvrant les flancs et le sommet.

11. Procédé selon la revendication 10, dans lequel chaque zone active (40) a une forme de pyramide tronquée de demi-angle au sommet β dont la base repose sur l'élément semiconducteur tridimensionnel (26), l'angle β étant strictement supérieur à 0°, de préférence compris entre 5° et 80°, plus préférentiellement compris entre 20° et 30°.

12. Procédé selon l'une quelconque des revendications 1 à 11, dans lequel au moins une partie de chaque élément semiconducteur tridimensionnel (26) est un microfil, un nanofil, ou un élément tronconique de taille micrométrique ou nanométrique.

13. Procédé selon l'une quelconque des revendications 1 à 12, dans lequel les éléments semiconducteurs tridimensionnels (26) sont dopés de type n.

14. Procédé selon la revendication 13, dans lequel chaque empilement (42) comprend une couche semiconductrice (44) en un composé III-V dopé de type p.

15. Procédé selon l'une quelconque des revendications 1 à 14, dans lequel les zones actives (40) sont les régions depuis lesquelles est émise la majorité du rayonnement électromagnétique fourni par les diodes électroluminescentes (DEL).

## Patentansprüche

1. Verfahren zum Herstellen einer optoelektronischen Vorrichtung (10; 55; 58; 60; 65, die lichtemittierende Dioden (DEL) aufweist, aufweisend Ausbilden dreidimensionaler Halbleiterelemente (26), die sich entlang paralleler Achsen (C) erstrecken und aus einer III-V-Verbindung geschaffen sind, mit einer Polarität des Gruppe-III-Elements der III-V-Verbindung, wobei das Verfahren ferner, für jedes Halbleiterelement, Ausbilden aufweist, und zwar eines aktiven Bereichs (40), der die Oberseite (30) des Halbleiterelements bedeckt, und eines Stapels (42) von Halbleiterschichten, die den aktiven Bereich bedecken, wobei der aktive Bereich durch Dampfabscheidung bei einem Druck von weniger als 66,6 mPa ausgebildet wird und Quantentöpfe (50) aufweist, die durch Sperrschichten (52) getrennt sind, wobei jeder Quantentopf (50) eine ternäre Legierung aufweist, die wenigstens ein erstes Gruppe-III-Element, das Gruppe-V-Element der III-V-Verbindung und ein zweites Gruppe-III-Element aufweist, **dadurch gekennzeichnet, dass** das Verhältnis des Atomflusses des ersten und des zweiten Gruppe-III-Elements zu dem Atomfluss des Gruppe-V-Elements im Bereich von 1 bis 3 liegt.

2. Verfahren nach Anspruch 1, wobei das Verhältnis des Atomflusses des ersten und zweiten Gruppe-III-Elements zum Atomfluss des Gruppe-V-Elements der III-V-Verbindung im Bereich von 1 bis 1,4, vorzugsweise von 1,1 bis 1,3 liegt.

3. Verfahren nach Anspruch 1 oder 2, wobei jeder Quantentopf (50) bei einer ersten Temperatur ausgebildet wird und jede Sperrschicht (52) bei einer zweiten Temperatur ausgebildet wird, die gleich der ersten Temperatur bis auf 50°C, bevorzugt bis auf 30°C, weiter bevorzugt bis auf 10°C, ist.

4. Verfahren nach einem der Ansprüche 1 bis 3, wobei die Quantentöpfe (50) und die Sperrschichten (52) durch molekulare Strahlepitaxie ausgebildet werden.

5. Verfahren nach einem der Ansprüche 1 bis 4, wobei das erste Gruppe-III-Element mit dem Gruppe-III-Element der III-V-Verbindung identisch ist.

6. Verfahren nach einem der Ansprüche 1 bis 5, wobei das Verhältnis des Atomflusses des ersten Gruppe-III-Elements zum Atomfluss des Gruppe-V-Elements der III-V-Verbindung zum Ausbilden der Quantentöpfe (50) von 0,01 bis 1 variiert.

7. Verfahren nach Anspruch 4 oder 5, wobei das Verhältnis des Atomflusses des zweiten Gruppe-III-Elements zum Atomfluss des Gruppe-V-Elements der III-V-Verbindung zum Ausbilden der Quantentöpfe (50) von 0,05 bis 5 variiert.

8. Verfahren nach einem der Ansprüche 1 bis 7, wobei die dreidimensionalen Halbleiterelemente (26) durch molekulare Strahlepitaxie ausgebildet werden.

9. Verfahren nach Anspruch 8, wobei das Verhältnis des Atomflusses des Gruppe-III-Elements der III-V-Verbindung zu dem Atomfluss des Gruppe-V-Elements der III-V-Verbindung zum Ausbilden der dreidimensionalen Halbleiterelemente (26) im Bereich von 0,35 bis 2 liegt.

10. Verfahren nach einem der Ansprüche 1 bis 9, wobei jeder aktive Bereich (40) eine Basis, Seiten (56) und eine Oberseite (57) aufweist, wobei die Basis auf dem dreidimensionalen Element (26) aufliegt, die Quantentöpfe Kanten aufweisen, die an den Seiten freiliegen, wobei der Stapel (42) die Seiten und die Oberseite bedeckt.

11. Verfahren nach Anspruch 10, wobei jeder aktive Bereich (40) die Form eines Pyramidenstumpfes mit halbem Scheitelwinkel β hat, dessen Basis auf dem dreidimensionalen Halbleiterelement (26) aufliegt, wobei der Winkel β größer als 0° ist, bevorzugt im Bereich von 5° bis 80°, weiter bevorzugt im Bereich von 20° bis 30°.

12. Verfahren nach einem der Ansprüche 1 bis 11, wobei wenigstens ein Teil eines jeden dreidimensionalen Halbleiterelements (26) ein Mikrodraht, ein Nanodraht oder ein kegelstumpfförmiges Element im Mikrometer- oder Nanometerbereich ist.

13. Verfahren nach einem der Ansprüche 1 bis 12, wobei die dreidimensionalen Halbleiterelemente (26) n-dotiert sind.

14. Verfahren nach Anspruch 13, wobei jeder Stapel (42) eine Halbleiterschicht (44) aufweist, die aus einer p-dotierten III-V-Verbindung gemacht ist.

15. Verfahren nach einem der Ansprüche 1 bis 14, wobei die aktiven Bereiche (40) die Bereiche sind, aus denen der größte Teil der elektromagnetischen Strahlung emittiert wird, die von den Leuchtdioden (DEL) geliefert wird.

## Claims

1. Method of manufacturing an optoelectronic device (10; 55; 58; 60; 65) comprising light-emitting diodes (DEL), comprising forming three-dimensional semiconductor elements (26), extending along parallel axes (C), made of a III-V compound, with a polarity of the group-III element of the III-V compound, the method further comprising, for each semiconductor element, forming an active area (40) covering the top (30) of the semiconductor element and a stack (42) of semiconductor layers covering the active area, the active area being formed by vapor deposition at a pressure lower than 66,6 mPa and comprising quantum wells (50) separated by barrier layers (52), each quantum well (50) comprising a ternary alloy comprising at least one first group-III element, the group-V element of the III-V compound, and a second group-III element, **characterized in that** the ratio of the atomic flux of the first and second group-III elements to the atomic flux of the group-V element is in the range from 1 to 3.

2. Method according to claim 1, wherein the ratio of the atomic flux of the first and second group-III elements to the atomic flux of the group-V element of the III-V compound is in the range from 1 to 1.4, preferably from 1.1 to 1.3.

3. Method according to claim 1 or 2, wherein each quantum well (50) is formed at a first temperature and each barrier layer (52) is formed at a second temperature equal to the first temperature to within 50°C, preferably to within 30°C, more preferably to within 10°C.

4. Method according to any of claims 1 to 3, wherein the quantum wells (50) and the barrier layers (52) are formed by molecular beam epitaxy.

5. Method according to any of claims 1 to 4, wherein the first group-III element is identical to the group-III element of the III-V compound.

6. Method according to any of claims 1 to 5, wherein the ratio of the atomic flux of the first group-III element to the atomic flux of the group-V element of the III-V compound, for the forming of the quantum wells (50), varies from 0.01 to 1.

7. Method according to claim 4 or 5, wherein the ratio of the atomic flux of the second group-III element to the atomic flux of the group-V element of the III-V compound, for the forming of the quantum wells (50), varies from 0.05 to 5.

8. Method according to any of claims 1 to 7, wherein the three-dimensional semiconductor elements (26) are formed by molecular beam epitaxy.

9. Method according to claim 8, wherein the ratio of the atomic flux of the group-III element of the III-V compound to the atomic flux of the group-V element of the III-V compound, for the forming of the three-dimensional semiconductor elements (26), is in the range from 0.35 to 2.

10. Method according to any of claims 1 to 9, wherein each active area (40) comprises a base, sides (56), and a top (57), the base resting on the three-dimensional element (26), the quantum wells comprising edges exposed on the sides, said stack (42) covering the sides and the top.

11. Method according to claim 10, wherein each active area (40) has the shape of a truncated pyramid of half apical angle β having its base resting on the three-dimensional semiconductor element (26), angle β being greater than 0°, preferably in the range from 5° to 80°, more preferably in the range from 20° to 30°.

12. Method according to any of claims 1 to 11, wherein at least a portion of each three-dimensional semiconductor element (26) is a microwire, a nanowire, or a micrometer- or nanometer-range frustoconical element.

13. Method according to any of claims 1 to 12, wherein the three-dimensional semiconductor elements (26) are n-type doped.

14. Method according to claim 13, wherein each stack (42) comprises a semiconductor layer (44) made of a p-type doped III-V compound.

15. Method according to any of claims 1 to 14, wherein the active areas (40) are the regions having most of the electromagnetic radiation supplied by the light-emitting diodes (DEL) emitted therefrom.
